# EUROPÄISCHE PATENTANMELDUNG

(11) **EP 1 722 003 A1**
(43) Veröffentlichungstag der Anmeldung: **15.11.2006**
(21) Anmeldenummer: 06006000.1
(22) Anmeldetag: 23.03.2006
(51) Int. Cl.: C23C 14/00

(54) **Legierter Körper als Target für das PVD-Verfahren, Verfahren zur Herstellung des legierten Körpers und PVD-Verfahren mit dem legierten Körper**

(30) Priorität: 12.05.2005 DE 102005021927
(71) Anmelder: Fette GmbH, 21493 Schwarzenbek (DE)
(72) Erfinder: Kölker, Werner Dr., 23909 Ratzeburg (DE)
(74) Vertreter: Hauck, Graalfs, Wehnert, Döring, Siemons

(57) **Zusammenfassung**

Legierter Körper als Target für das PVD-Verfahren, der metallische und nichtmetallische Stoffe enthält, wobei er aus einem Verbundwerkstoff besteht, bei dem in eine metallische Legierung oder in ein Reinmetall mindestens ein nicht reinmetallischer, mindestens ein reaktives Element oder Metalloid enthaltender Werkstoff eingebettet ist.

## Beschreibung

Die Erfindung bezieht sich auf einen legierten Körper als Target für das PVD-Verfahren nach dem Patentanspruch 1.

Es ist bekannt, Bauteile, insbesondere Werkzeuge, insbesondere Zerspanungswerkzeuge, nach dem PVD-Verfahren mit einer oder mehreren Schichten zu versehen, um eine Reihe von Eigenschaften des Bauteils zu verbessern. Bei dem PVD-Verfahren wird das Beschichtungsmaterial in die Gasphase überführt und auf einem Substrat abgeschieden. Je nach der chemischen Art der herzustellenden Schicht werden metallische und nicht metallische chemische Elemente benötigt, wobei letztere auch als Metalloide bezeichnet werden. Eine übliche Vorgehensweise, diese Stoffe in den Prozeß einzubringen, ist derart, dass die metallischen Stoffe durch unterschiedliche Verfahren der Verdampfung oder des Sputterns in den gasförmigen Zustand überführt werden und die nicht metallischen Stoffe - beispielsweise Stickstoff für nitridische Schichten oder Kohlenstoff für karbidische Schichten - gasförmig in den für das PVD-Verfahren vorgesehenen Reaktor eingeleitet werden. Bei Prozeßdrücken im Fein- bis Hochvakuumbereich wird dann durch Anlegen elektrischer Spannungen eine Glimmentladung gezündet, wodurch die gasförmigen Stoffe teilweise ionisiert werden und ein Plasma entsteht. Die Plasmaenergie dient als Triebkraft, um die Stoffe auf den zu beschichtenden Bauteilen chemisch reagieren und sich niederschlagen zu lassen. Diese Art der Schichtenerzeugung wird auch als reaktives PVD-Verfahren bezeichnet, bei dem beispielsweise der eingebrachte Stickstoff ein Reaktivgas ist. Mit der bekannten Verfahrenstechnik werden z.B. TiN-Schichten aus Titandampf und gasförmig eingeleitetem Stickstoff gebildet.

Es ist ferner bekannt, beim PVD-Verfahren ohne das Einleiten von Reaktivgasen zu arbeiten. Bei diesem Verfahren wird beispielsweise mit dem Sputtern gearbeitet, wobei der herzustellende Schichtwerkstoff bereits in Form eines sog. Zerstäubungstargets in den Prozeß eingebracht wird, beispielsweise als ein keramischer TiN-Körper. Mittels Ionenzerstäuben (Sputtern) wird das Vormaterial in den gasförmigen Zustand überführt und kondensiert auf dem zu beschichtenden Bauteil mit oder ohne Plasmaunterstützung. Das Zerstäuben elektrisch nicht leitender Werkstoffe erfordert spezielle Verfahren, beispielsweise das hochfrequenzunterstützte Zerstäuben (HF-Betrieb). Ein Gleichspannungsbetrieb ist für derartige Targetstoffe nicht realisierbar.

Aus EP 1 348 776 A1 ist ein AICr-Target für eine PVD-Beschichtung bekannt geworden, wobei der Chromgehalt > 5 % sein kann. Aus EP 0 603 486 B1 ist ein CrAl-Sputtertarget sowie ein Reinmetall-Ionenätz-Arc-Target bekannt geworden. Aus EP 0 668 369 B1 ist ein Target aus TiAlZrHfCN und Nb, Mo, Ta und W bekannt geworden.

Die beiden beschriebenen Verfahren haben Vor- und Nachteile. Bei dem ohne Reaktivgase arbeitenden Verfahren werden beispielsweise die Einleitung der Gase kontrollierende Anlagenkomponenten und Regelsysteme nicht benötigt. Andererseits ist die Stöchiometrie vorgegeben und kann nur durch Veränderung des Targetmaterials modifiziert werden. Bei dem mit Reaktivgas arbeitenden Verfahren ist über die Prozeßführung eine breitere Palette unterschiedlicher stöchiometrischer Zusammensetzungen der beteiligten Elemente realisierbar. Hierzu wird jedoch ein entsprechendes Regelsystem in der Beschichtungsanlage benötigt. Die Zufuhr weiterer Reaktivgase zur Herstellung komplexerer Schichtwerkstoffzusammensetzungen benötigt daher für jedes zusätzliche Reaktivgas einen derartigen Regelkreis. Anlagentechnisch wird daher bei der Generierung neuer hochkomplexer Schichtsysteme die Flexibilität herabgesetzt.

Der Erfindung liegt die Aufgabe zugrunde, einen legierten Körper als Target für das PVD-Verfahren zu schaffen, der die Möglichkeit bietet, die Nachteile des reaktiven und des nicht-reaktiven PVD-Verfahrens zu verringern und deren Vorteile zu kombinieren.

Diese Aufgabe wird durch die Merkmale des Patentanspruchs 1 gelöst.

Bei der Erfindung ist der legierte Körper ein Verbundwerkstoff, bei dem in eine metallische Legierung ein nicht reinmetallischer, mindestens ein reaktives Element enthaltender Werkstoff eingebettet ist. Mit anderen Worten, der erfindungsgemäße legierte Körper ist ein mehrphasiger Körper aus einem Metall bzw. einer Metalllegierung und einer nicht reinmetallischen Stoffzusammensetzung, welche Stoffe nach Art eines Verbundwerkstoffs in geeigneter Weise miteinander verbunden sind. Nach einer Ausgestaltung der Erfindung sind etwa Anteile des nicht reinmetallischen Werkstoffs in der metallischen Legierung feindispers verteilt. Alternativ kann der nicht reinmetallische Werkstoff in Form von Fasern, Platten oder ähnlichen Konfigurationen in der metallischen Legierung angeordnet sein.

Die Erfindung hat den großen Vorteil, dass für nicht reinmetallische Targets, die Reaktivelemente enthalten, zu Verdampfungszwecken die Lichtbogentechnik eingesetzt werden kann. Wie eingangs erwähnt, sind metallkeramische Targets an sich bekannt. Da sie elektrisch nicht leitend sind, läßt sich die Lichtbogenverdampftechnik nicht einsetzen, vielmehr muß ein spezielles Verfahren eingesetzt werden, wie beispielsweise das bereits erwähnte hochfrequenzunterstützte Zerstäuben.

Ein weiterer Vorteil der Erfindung liegt darin, dass ein nicht metallisches Element, beispielsweise Sauerstoff wie bei einem nicht reaktiven Verfahren in den PVD-Prozeß eingebracht werden kann. Selbstverständlich können aber zusätzlich Reaktivgase im PVD-Verfahren eingeleitet werden. Da jedoch die interessanten, nicht metallischen Elemente sich insbesondere in keramischen Werkstoffen befinden, häufig in Kombination mit metallischen Elementen, die auch für den PVD-Prozeß benötigt werden, beispielsweise Sauerstoff und Titan in keramischen Titanaten oder Aluminium und Sauerstoff in Aluminiumoxid-Keramiken oder Silizium und Sauerstoff in Form von Quarzglas, ist nach einer Ausgestaltung der Erfindung das Nicht-Metall keramisch oder glasartig gebildet. Die Keramik kann eine Nitrid-, Carbid-, Oxid- oder Mischkeramik sein, wobei die Keramik zum Beispiel Siliziumoxid ist. Der keramische Werkstoff kann beispielsweise ein Silikat, Titanat, Mullit, Steatit, Cordierit, Sialon, Borkarbid oder Aluminiumnitrid oder eine Mischung aus diesen sein. Der keramische Werkstoff kann ganz oder teilweise aus keramischem Siliziumnitrid bestehen.

Nach einer weiteren Ausgestaltung der Erfindung kann der nicht reinmetallische Werkstoff teilweise oder ganz aus mindestens einem der chemischen Elemente Al, Si, F, Cl, S oder Y sowie Elementen aus den Gruppen 4 bis 6 des Periodensystems bestehen.

Nach einer weiteren Ausgestaltung der Erfindung kann der legierte Körper einen das Kristallwachstum beeinflussenden Stoff enthalten, der nach einer weiteren Ausgestaltung der Erfindung ein Kornfeiner sein kann. Dieser kann nach einer Ausgestaltung der Erfindung Yttriom-Aluminium-Granat sein. Alternativ kann Silizium vorgesehen werden.

Alternativ zur Keramik als nicht rein metallischer Anteil des Verbundwerkstoffes des erfindungsgemäßen legierten Körpers kann nach einer Ausgestaltung der Erfindung der nicht reinmetallische Werkstoff seinerseits ein Verbundwerkstoff aus einem Metall oder einer Metall-Legierung und einem Nichtmetall sein. Das Nichtmetall kann keramisch sein, beispielsweise Wolfram-Karbid, Titan-Karbid oder dergleichen. Vorzugsweise ist der Verbundwerkstoff ein Hartmetall, Cermet oder dergleichen.

Ein gemäß der Erfindung aufgebauter Verbundkörper bietet ferner den Vorteil, dass die beim Lichtbogenverdampfen entstehenden sogenannten Droplets nicht mehr reinmetallische Niederschläge auf den Bauteilen bilden, sondern dass die Droplets feindispers verteilte Einlagerungen enthalten können, demzufolge aus einem Metallmatrix-Kompositwerkstoff sind (MMC-Aufbau). Es kommt dadurch zu einer Dispersionshärtung der Droplets, was zu günstigeren tribologischen Verschleißeigenschaften führt, wenn eine Beschichtung bei Werkzeugen vorgenommen wird. Neben der Dispersionshärtung sind hier auch reibungsmindernde Eigenschaften der eingelagerten Komponenten interessant, der verwendete Stoff also als tribochemisches Additiv angesehen werden kann.

Es wurde bereits erwähnt, dass über Zusatzstoffe Einfluß auf das Schichtwachstum genommen werden kann, beispielsweise durch die Auswahl einer geeigneten Substanz.

Die Erfindung hat ferner den Vorteil, dass Sauerstoff bereits im Target als gebunden in Metalloxidform vorhanden ist. Dadurch entstehen keine reinmetallischen Droplets. Die Erfindung ermöglicht die Beeinflussung des Kristallwachstums in der Schicht beim PVD-Verfahren und die Beeinflussung der tribologischen Schichteigenschaften durch stöchiometrische Vorgabe im Target. Die Erfindung ermöglicht ferner einen geringeren Regelaufwand während des Beschichtungsprozesses sowie eine größere und vereinfachte Reproduzierbarkeit des PVD-Verfahrens.

Durch Anwendung der Lichtbogenverdampfung ist ein apparatetechnisch unaufwendiges Verfahren möglich. Der erfindungsgemäße legierte Körper kann pulvermetallurgisch oder sintertechnisch hergestellt werden, wodurch sich besonders gut ein Verbundwerkstoff herstellen läßt. Die Auswahl der Zusatzstoffe kann auf der Basis handelsüblicher Stoffe erfolgen, z.B. Keramiken.

Es versteht sich, dass auch andere Herstellungsverfahren für den erfindungsgemäßen legierten Körper möglich sind, beispielsweise ein schmelzmetallurgisches, gießtechnisches oder spritzgießtechnisches Verfahren oder eine Herstellung mittels Laser-Legierens oder auch mittels sogenanntem Explosionsverdichten. Neben dem besonders vorteilhaften Lichtbogenverdampfen kann eine Hohlkathodenverdampfung, Niedervoltverdampfung, ein Sputtern oder eine Kombination aus diesen Verfahren verwendet werden, um den legierten Körper in den gasförmigen Zustand zu bringen unter Erzeugung eines ionischen Plasmas.

Beim PVD-Verfahren kann zusätzlich ein Gemisch aus Reaktiv- und Edelgasen zugeführt werden.

Das erfindungsgemäße Verfahren kann insbesondere zur Beschichtung von zerspanenden und Umformwerkzeugen vorgesehen werden. Als zerspanende Werkzeuge kommen etwa Fräser, Wälzfräser, Bohrer, Gewindebohrer, Gewindeformer, Schneidplatten oder dergleichen in Betracht. Als Umformwerkzeuge kommen etwa Rollwerkzeuge, insbesondere Gewinderollwerkzeuge, in Betracht.

## Patentansprüche

1. Legierter Körper als Target für das PVD-Verfahren, der metallische und nichtmetallische Stoffe enthält, **dadurch gekennzeichnet, dass** er aus einem Verbundwerkstoff besteht, bei dem in eine metallische Legierung oder in ein Reinmetall mindestens ein nicht reinmetallischer, mindestens ein reaktives Element oder Metalloid enthaltender Werkstoff eingebettet ist.

2. Legierter Körper nach Anspruch 1, **dadurch gekennzeichnet, dass** Anteile des nicht reinmetallischen Werkstoffes in der metallischen Legierung feindispers verteilt sind.

3. Legierter Körper nach Anspruch 1, **dadurch gekennzeichnet, dass** der nicht reinmetallische Werkstoff in Form von Fasern, Platten oder dergleichen in der metallischen Legierung eingebunden ist.

4. Legierter Körper nach einem der Ansprüche 1 bis 3, **dadurch gekennzeichnet, dass** der nicht reinmetallische Werkstoff seinerseits ein Verbundwerkstoff aus Metall oder einer Metall-Legierung und mindestens einem nichtmetallischen Werkstoff ist.

5. Legierter Körper nach Anspruch 4, **dadurch gekennzeichnet, dass** der nichtmetallische Werkstoff keramisch ist.

6. Legierter Körper nach Anspruch 5, **dadurch gekennzeichnet, dass** die Keramik ein Wolfram-Karbid, Titankarbid oder dergleichen ist.

7. Legierter Körper nach Anspruch 4, 5 oder 6, **dadurch gekennzeichnet, dass** der Verbundwerkstoff ein Hartmetall, Cermet oder dergleichen ist.

8. Legierter Körper nach einem der Ansprüche 1 bis 3, **dadurch gekennzeichnet, dass** der nicht reinmetallische Werkstoff ein keramischer oder glasartiger Werkstoff ist.

9. Legierter Körper nach Anspruch 8, **dadurch gekennzeichnet, dass** er eine Nitrid-, Karbid-, Oxid- oder Mischkeramik ist.

10. Legierter Körper nach Anspruch 9, **dadurch gekennzeichnet, dass** der keramische Werkstoff Siliziumoxid ist.

11. Legierter Körper nach Anspruch 9, **dadurch gekennzeichnet, dass** der keramische Werkstoff ein Silikat, Titanat, Mullit, Steatit, Cordierit, Sialon, Borkarbid oder Aluminiumnitrid, oder eine Mischung aus diesen ist.

12. Legierter Körper nach Anspruch 9, **dadurch gekennzeichnet, dass** Anteile von keramischem Siliziumnitrid vorgesehen sind.

13. Legierter Körper nach einem der Ansprüche 1 bis 13, **dadurch gekennzeichnet, dass** der nicht reinmetallische Werkstoff teilweise oder ganz aus mindestens einem der chemischen Elemente Al, Si, F, Cl, S oder Y sowie Elementen aus den Gruppen 4 bis 6 des Periodensystems besteht.

14. Legierter Körper nach einem der Ansprüche 1 bis 13, **dadurch gekennzeichnet, dass** seine Dichte mindestens bei 90 %, vorzugsweise bei mindestens 99,8 % liegt.

15. Legierter Körper nach einem der Ansprüche 1 bis 14, **dadurch gekennzeichnet, dass** mindestens ein das Kristallwachstum beeinflussender Stoff enthalten ist.

16. Legierter Körper nach Anspruch 15, **dadurch gekennzeichnet, dass** ein Kornfeiner vorgesehen ist.

17. Legierter Körper nach Anspruch 16, **dadurch gekennzeichnet, dass** ein Yttrium-Aluminium-Granat vorgesehen ist.

18. Legierter Körper nach Anspruch 15, **dadurch gekennzeichnet, dass** Silizium vorgesehen ist.

19. Verfahren zur Herstellung des legierten Körpers nach einem der Ansprüche 1 bis 18, **dadurch gekennzeichnet, dass** er ganz oder teilweise gießtechnisch, schmelzmetallurgisch, preßtechnisch, spritzgußtechnisch, pulvermetallurgisch, sintertechnisch, mittels Explosionsverdichten, durch Auftragsschweißen oder durch Laser-Legieren hergestellt wird.

20. PVD-Verfahren mit einem legierten Körper nach einem der Ansprüche 1 bis 18, **dadurch gekennzeichnet, dass** der legierte Körper durch Lichtbogenverdampfung, Hohlkathodenverdampfung, Niedervoltbogenverdampfung, Sputtern oder eine Kombination aus diesen Verfahren, in den gasförmigen Zustand gebracht und unter Erzeugung eines ionischen Plasmas ein Hartwerkstoff auf einem Bauteil abgeschieden wird.

21. Verfahren nach Anspruch 20, **dadurch gekennzeichnet, dass** ein Gemisch aus Reaktiv- und Edelgasen zugeführt wird.

22. Verfahren nach Anspruch 20 oder 21, **dadurch gekennzeichnet, dass** als Bauteile zerspanende oder Umformwerkzeuge vorgesehen werden.

23. Verfahren nach Anspruch 22, **dadurch gekennzeichnet, dass** Fräser, Wälzfräser, Bohrer, Gewindebohrer, Gewindeformer, Schneidplatten oder dergleichen beschichtet werden.

24. Verfahren nach Anspruch 22, **dadurch gekennzeichnet, dass** Rollwerkzeuge, insbesondere Gewinderollwerkzeuge, beschichtet werden.

25. Bauteil nach Anspruch 22, 23 oder 24, **dadurch gekennzeichnet, daß** es mittels einem Verfahren nach Anspruch 20 beschichtet wird.
